# FASCICULE DE BREVET EUROPEEN

(11) **EP 2 829 508 B1**
(45) Date de publication et mention de la délivrance du brevet: **11.03.2020**
(21) Numéro de dépôt: 14178068.4
(22) Date de dépôt: 22.07.2014
(51) Int. Cl.: B81B 3/00

(54) **Structure d'encapsulation comprenant un capot renforce mécaniquement et à effet getter**
Einkapselungsstruktur, die eine mechanisch verstärkte Hülle mit Getter-Effekt umfasst
Encapsulation structure including a mechanically-reinforced cover with getter effect

(30) Priorité: 26.07.2013 FR 1357386
(43) Date de publication de la demande: 28.01.2015
(73) Titulaire: Commissariat à l'Énergie Atomique et aux Énergies Alternatives, 75015 Paris (FR)
(72) Inventeur: Baillin, Xavier, 38920 Crolles (FR); Diem, Bernard, 38130 Echirolles (FR); Polizzi, Jean-Philippe, 38000 Grenoble (FR); Rouzaud, André, 38170 Seyssinet (FR)
(74) Mandataire: Brevalex

(56) Documents cités:
- EP-A1- 1 640 333
- EP-A2- 1 640 328
- FR-A1- 2 901 264
- US-A- 5 268 533

## Description

### DOMAINE TECHNIQUE ET ART ANTÉRIEUR

L'invention concerne le domaine des structures d'encapsulation comportant un ou plusieurs micro-dispositifs encapsulés dans une ou plusieurs cavités de façon hermétique, par exemple sous atmosphère contrôlée. L'invention s'applique avantageusement à l'encapsulation de micro-dispositifs de type MEMS (microsystème électromécanique) résonants.

Le terme « micro-dispositif » désigne tout microsystème de type MEMS, NEMS (nanosystème électromécanique), MOEMS (microsystème opto-électromécanique), NOEMS (nanosystème opto-électromécanique), ainsi que tout type de composant ou microcomposant électronique, optique, ou optoélectronique.

Il existe actuellement deux grandes familles de techniques d'encapsulation, ou « pré-packaging », de micro-dispositifs permettant d'assurer la protection de ces micro-dispositifs, notamment des parties mobiles de ces micro-dispositifs, lors de leur manipulation et des étapes mises en œuvre ultérieurement (découpe, mise en boitier, etc.) :
- Packaging par report de substrat, ou « Wafer Cap Packaging », dont le capot est formé par un substrat, ou wafer, de silicium ou de verre, généralement micro-usiné et collé au substrat sur lequel se trouvent des micro-dispositifs, ce capot étant ensuite aminci jusqu'à obtenir une épaisseur de quelques dizaines de microns pour optimiser l'encombrement de ce composant avant son conditionnement définitif ou en vue de l'empiler en trois dimensions avec d'autres composants ;
- Packaging Couche Mince (PCM, ou TFP pour « Thin Film Packaging »), comprenant une réalisation, directement au-dessus du micro-dispositif, d'un film mince (d'épaisseur par exemple comprises entre environ 1 et 10 microns) formant le capot de la structure dans laquelle le micro-dispositif est encapsulé.

Compte tenu des manipulations subies par les micro-dispositifs ainsi encapsulés, il est important que les capots protégeant ces micro-dispositifs aient une bonne résistance mécanique afin de résister aux contraintes engendrées par ces manipulations.

Plusieurs types de renforcements mécaniques ont été proposés afin d'augmenter la solidité de ces capots minces ou amincis qui sont soumis, par exemple lors d'étapes de surmoulage, à des pressions égales ou supérieures à 100 bars qui induisent généralement des déformations importantes pouvant conduire à la rupture des capots subissant de telles pressions.

Le document FR 2 901 264 décrit la réalisation de renforts mécaniques sous forme de saillies au niveau de la paroi sommitale d'un capot obtenu par dépôt d'une ou plusieurs couches minces. Ce procédé n'est toutefois compatible qu'avec la réalisation de capots en couches minces et non avec la réalisation de capots par reports de substrats. De plus, avec de tels renforts réalisés à l'extérieur de la cavité, il existe un fort risque qu'une délamination se produise entre les renforts et le capot car si l'ensemble défini par les éléments en saillie est plus rigide mécaniquement que le capot, les forces exercées sur le capot peuvent alors provoquer une délamination entre le capot et les renforts. Enfin, les renforts décrits dans ce document ne sont pas suffisants pour que la structure d'encapsulation puisse supporter des pressions supérieures ou égales à environ 100 bars, qui correspondent aux pressions rencontrées lors de la mise en œuvre d'une étape de surmoulage du micro-dispositif ainsi encapsulé.

Le document FR 2 955 999 décrit le renfort mécanique d'un capot obtenu par dépôt d'une ou plusieurs couches minces, via un dépôt localisé d'une portion de matériau de renfort mécanique recouvrant le capot. Bien que le renfort mécanique obtenu soit satisfaisant en termes de résistance mécanique apportée au capot, la zone de renfort continue ainsi réalisée sur toute la surface du capot empêche d'accéder au capot ou au micro-dispositif, empêchant par exemple d'effectuer des contrôles ou des mesures optiques sur l'intérieur du capot ou sur le micro-dispositif encapsulé. De plus, les contraintes résiduelles qui sont localisées à l'interface entre le matériau de renfort et la couche d'encapsulation peuvent avoir un effet néfaste sur la tenue mécanique de l'interface. Enfin, ce procédé n'est compatible qu'avec la réalisation de capots en couches minces et non avec des capots formés par report de substrats.

Enfin, dans les deux solutions de renfort mécanique décrites ci-dessus, aucune solution n'est décrite pour réaliser un contrôle de l'atmosphère dans laquelle le micro-dispositif est encapsulé.

Le document EP 1 640 333 A1 décrit une structure d'encapsulation dans laquelle un matériau getter recouvert d'une couche de protection est disposé contre le capot. Le document EP1 640 328 décrit une structure d'encapsulation et un procédé associé avec utilisation de renforts.

### EXPOSÉ DE L'INVENTION

Un but de la présente invention est de proposer une structure d'encapsulation dont le capot est renforcé mécaniquement, qui soit compatible avec une réalisation par packaging couche mince ou par report de substrat, et dont l'atmosphère d'encapsulation puisse être aisément contrôlée.

Pour cela, la présente invention propose une structure d'encapsulation d'au moins un micro-dispositif réalisé sur et/ou dans un substrat et disposé dans au moins une cavité formée entre un substrat et un capot solidarisé au substrat, dans laquelle le capot comporte au moins :
- une couche d'un premier matériau dont une face forme une paroi intérieure de la cavité, et
- des portions de renfort mécanique solidarisées au moins à ladite face de la couche du premier matériau, recouvrant en partie ladite face de la couche du premier matériau et présentant des propriétés d'absorption et/ou d'adsorption gazeuse, ces portions de renfort mécanique comprenant au moins un deuxième matériau dont le module d'Young est supérieur à celui du premier matériau.

Les portions de renfort mécanique ainsi intégrées au capot raidissent et consolident fortement la structure d'encapsulation et la rendent résistante notamment aux étapes ultérieures de manipulation et de mise en boitier que la structure d'encapsulation est destinée à subir. De plus, en réalisant ces portions de renfort mécanique au niveau de la paroi intérieure de la cavité et avec un matériau dont le module d'Young est supérieur à celui du matériau de la couche du capot, la réalisation d'un tel capot est compatible autant avec un packaging couche mince qu'avec un packaging par report de substrat avantageusement aminci. Cette structure d'encapsulation ne fait appel qu'à des éléments compatibles avec les techniques classiques de la microélectronique.

De plus, les portions de renfort mécanique présentent des propriétés d'absorption et/ou d'adsorption gazeuse, c'est-à-dire intègrent une fonction getter qui va permettre de contrôler l'atmosphère dans la cavité, à la fois en termes de nature et de pression partielle des gaz résiduels dans la cavité.

Un telle structure d'encapsulation est avantageusement utilisée pour protéger des micro-dispositifs par exemple MEMS de type inertiel comprenant des parties mobiles (poutres libres ou encastrées, membranes, masses sismiques, microtubes, ...), avant leur intégration dans une ligne de packaging finale. Ceci est de plus réalisé grâce à des technologies de fabrication collectives à coût réduit. Une telle structure d'encapsulation peut également être reportée directement sur un circuit imprimé, ou PCB (« Printed Circuit Board »).

Le deuxième matériau peut être un matériau getter métallique. Ainsi, il est possible de réaliser les portions de renfort mécanique avec un matériau présentant à la fois des propriétés d'absorption et/ou d'adsorption gazeuse et des propriétés de forte résistance mécanique.

Chacune des portions de renfort mécanique comporte au moins une première couche du deuxième matériau et au moins une deuxième couche d'un troisième matériau getter métallique telles que la première couche du deuxième matériau soit disposée entre la couche du premier matériau et la deuxième couche du troisième matériau et/ou soit recouverte par la deuxième couche du troisième matériau.

Ainsi, la réalisation de chacune des portions de renfort mécanique avec ces différentes couches de matériaux permet de surmonter les contraintes liées aux épaisseurs maximales de réalisation des matériaux utilisés pour former les portions de renfort mécanique. Une telle structure multicouches des portions de renfort mécanique est avantageusement utilisée pour réaliser des portions de renfort mécanique dont l'épaisseur est supérieure à environ 0,5 µm.

De plus, dans cette configuration, la première couche du deuxième matériau peut servir de sous-couche d'ajustement de la température d'activation thermique du troisième matériau getter métallique. Le deuxième matériau peut dans ce cas être un métal tel que du Cr et/ou du Ti et/ou du Co et/ou Fe et/ou du Mn et/ou du Mo et/ou du Ta et/ou du V et/ou du W, et/ou avantageusement du Ru et/ou du Pt et/ou du Cr et/ou du Ni. Des détails de réalisation d'une telle sous-couche d'ajustement sont décrits par exemple dans le document FR 2 922 202.

Chacune des portions de renfort mécanique peut comporter un empilement de couches dont au moins deux desdites couches forment un bilame exerçant sur le capot une force dirigée vers l'extérieur de la cavité. Les deux couches formant le bilame peuvent correspondre à la première couche du deuxième matériau et à la deuxième couche du troisième matériau getter métallique.

Le premier matériau peut être à base de Si et/ou de silice et/ou de nitrure de silicium, et le deuxième matériau peut être à base de Cr et/ou de Ti et/ou de Co et/ou de Fe et/ou de Mn et/ou de Mo et/ou de Ta et/ou de V et/ou de W et/ou de Pd et/ou de Rh et/ou de Pt et/ou de Ru et/ou de Zr. Lorsque l'un des matériaux getter métalliques comporte du Zr, ce matériau peut être associé à un des autres matériaux mentionnés ci-dessus dont le module d'Young est supérieur à celui du premier matériau.

Le ou les matériaux getter métalliques peuvent être à base de Cr et/ou de Ti et/ou de Co et/ou de Fe et/ou de Mn et/ou de Mo et/ou de Ta et/ou de V et/ou de W et/ou de Pd et/ou de Rh et/ou de Pt et/ou de Ru et/ou de Zr.

L'expression « à base de » peut désigner aussi bien le matériau en question qu'un de ses alliages.

Chacune des portions de renfort mécanique peut être de forme sensiblement parallélépipédique rectangle, les portions de renfort mécanique pouvant être disposées sensiblement parallèlement les unes par rapport aux autres. En variante, les portions de renfort mécanique peuvent former un maillage sur ladite face de la couche du premier matériau. Ces configurations des portions de renfort mécanique permettent à ces portions de jouer un rôle positif dans le cas accidentel de l'apparition de fissures dans la couche du premier matériau en déviant ces fissures aux interfaces entre la couche du premier matériau et les portions de renfort mécanique.

Un rapport r = h/H peut être compris entre environ 0,6 et 0,9, et un rapport R = b/t peut être supérieur ou égal à environ 0,7, avec :
h : épaisseur de la couche du premier matériau ;
H : somme de h et de l'épaisseur d'une des portions de renfort mécanique ;
b : largeur d'une des portions de renfort mécanique ;
t : période avec laquelle les portions de renfort mécanique sont disposées sur la couche du premier matériau.

La structure d'encapsulation peut comporter en outre des vias électriquement conducteurs réalisés à travers l'épaisseur du substrat et/ou de la couche du premier matériau, à côté de la cavité. De tels vias peuvent former par exemple des accès électriques au micro-dispositif encapsulé.

L'invention concerne également un dispositif microélectronique comportant au moins deux structures d'encapsulation telles que décrites ci-dessus et disposées l'une au-dessus de l'autre, dans lequel au moins un via électriquement conducteur d'une première des deux structures d'encapsulation est relié électriquement à au moins un via électriquement conducteur d'une deuxième des deux structures d'encapsulation directement ou par l'intermédiaire d'un interposeur. Ainsi, il est possible par exemple de relier électriquement au moins deux micro-dispositifs ainsi encapsulés et dont les structures d'encapsulation sont superposées l'une au-dessus de l'autre. Lorsque les capots de ces structures d'encapsulation correspondent à des couches minces ou des substrats amincis, le dispositif ainsi obtenu présente une faible épaisseur et facilite l'assemblage en trois dimensions des structures d'encapsulation, c'est-à-dire la superposition de ces structures d'encapsulation. Les micro-dispositifs superposés peuvent avoir des fonctions différentes, l'un correspondant par exemple à un gyromètre et l'autre correspondant à un accéléromètre. Un tel dispositif microélectronique peut être reporté directement sur un PCB.

L'invention concerne en outre un procédé d'encapsulation d'au moins un micro-dispositif, comportant au moins les étapes de :
- réalisation du micro-dispositif sur et/ou dans un substrat ;
- réalisation de portions de renfort mécanique solidarisées à au moins une face d'une couche d'un premier matériau, recouvrant en partie ladite face de la couche du premier matériau et présentant des propriétés d'absorption et/ou d'adsorption gazeuse, la couche du premier matériau et les portions de renfort mécanique formant un capot ;
- solidarisation du capot au substrat telle que le micro-dispositif soit encapsulé dans une cavité formée entre le capot et le substrat ;
et dans lequel les portions de renfort mécanique comprennent au moins un deuxième matériau dont le module d'Young est supérieur à celui du premier matériau.

Un tel procédé d'encapsulation par report de substrat permet d'obtenir une structure d'encapsulation telle que décrite ci-dessus. Un tel procédé correspond également à un procédé d'encapsulation par report d'un capot formé par dépôt d'une ou plusieurs couches minces dans un moule.

L'invention concerne également un procédé d'encapsulation d'au moins un micro-dispositif, comportant au moins les étapes de :
- réalisation du micro-dispositif sur et/ou dans un substrat ;
- réalisation d'une portion de matériau sacrificiel au moins sur le micro-dispositif et telle que le volume occupé par la portion de matériau sacrificiel correspond à au moins une partie d'un volume d'une cavité dans laquelle le micro-dispositif est destiné à être encapsulé ;
- réalisation de portions de renfort mécanique sur et/ou dans la portion de matériau sacrificiel et présentant des propriétés d'absorption et/ou d'adsorption gazeuse ;
- dépôt d'une couche d'un premier matériau recouvrant au moins les portions de renfort mécanique et la portion de matériau sacrificiel ;
- gravure de la portion de matériau sacrificiel, formant la cavité dans laquelle le micro-dispositif est encapsulé ;
et dans lequel les portions de renfort mécanique comprennent au moins un deuxième matériau dont le module d'Young est supérieur à celui du premier matériau.

Un tel procédé d'encapsulation de type PCM permet d'obtenir une structure d'encapsulation telle que décrite ci-dessus.

Chacune des portions de renfort mécanique est réalisée au moins par un dépôt d'une première couche du deuxième matériau et d'une deuxième couche d'un troisième matériau getter métallique telles que la première couche du deuxième matériau soit disposée entre la couche du premier matériau et la deuxième couche du troisième matériau et/ou soit recouverte par la deuxième couche du troisième matériau.

Chacune des portions de renfort mécanique peut être réalisée par un dépôt d'un empilement de couches dont au moins deux desdites couches forment un bilame exerçant sur le capot une force dirigée vers l'extérieur de la cavité.

Le procédé peut comporter en outre, après la solidarisation du capot au substrat ou la gravure de la portion de matériau sacrificiel, la réalisation de vias électriquement conducteurs à travers l'épaisseur du substrat et/ou de la couche du premier matériau, à côté de la cavité.

L'invention concerne enfin un procédé de réalisation d'un dispositif microélectronique, comportant la mise en œuvre d'un procédé d'encapsulation tel que décrit ci-dessus et formant au moins deux structures d'encapsulation, lesdites structures d'encapsulation étant disposées l'une au-dessus de l'autre, au moins un via électriquement conducteur d'une première des deux structures d'encapsulation étant ensuite relié électriquement à au moins un via électriquement conducteur d'une deuxième des deux structures d'encapsulation directement ou par l'intermédiaire d'un interposeur.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une vue en coupe d'une structure d'encapsulation, objet de la présente invention, selon un premier mode de réalisation ;
- les figures 2 et 3 représentent respectivement une vue en coupe de profil et une vue de dessous d'une partie d'un premier exemple de réalisation d'un capot d'une structure d'encapsulation, objet de la présente invention ;
- les figures 4 et 5 représentent des vues en coupe de profil partielle de variantes du capot de la structure d'encapsulation selon le premier exemple de réalisation, objet de la présente invention ;
- la figure 6 représente une vue de dessous d'un partie d'un deuxième exemple de réalisation d'un capot d'une structure d'encapsulation, objet de la présente invention ;
- la figure 7 représente une vue en coupe d'une structure d'encapsulation, objet de la présente invention, selon une variante du premier mode de réalisation ;
- la figure 8 représente une vue en coupe d'une structure d'encapsulation, objet de la présente invention, selon un deuxième mode de réalisation ;
- les figures 9A et 9B représentent des vues en coupe d'une structure d'encapsulation, objet de la présente invention, selon d'autres variantes de réalisation ;
- les figures 10A et 10B représentent des vues en coupe d'un dispositif microélectronique, objet de la présente invention, comportant plusieurs structures d'encapsulation, également objets de la présente invention, superposées et reliées électriquement entre elles ;
- la figure 10C représente une vue en coupe de plusieurs structures d'encapsulation et dispositifs microélectroniques reliés électriquement entre eux par l'intermédiaire d'un interposeur ;
- les figures 11A à 11E représentent les étapes d'un procédé de réalisation d'une structure d'encapsulation, objet de la présente invention, selon le deuxième mode de réalisation ;
- les figures 12A à 12F représentent les étapes d'un procédé de réalisation d'une structure d'encapsulation, objet de la présente invention, selon le premier mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

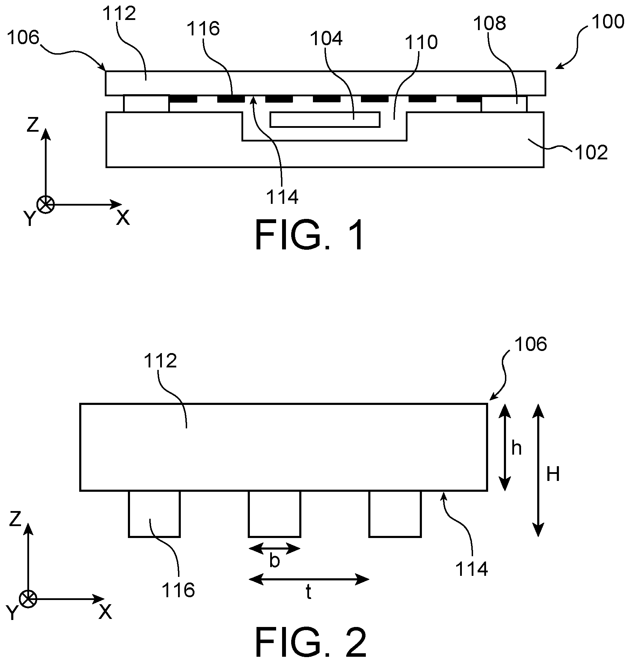

On se réfère tout d'abord à la figure 1 qui représente une vue en coupe d'une structure d'encapsulation 100 selon un premier mode de réalisation.

La structure d'encapsulation 100 comporte un substrat 102 dans lequel est réalisé un micro-dispositif 104. Ce micro-dispositif 104 est par exemple un MEMS de type inertiel comprenant une ou plusieurs parties mobiles (poutres, membranes, masses sismiques, microtubes, etc.). Un capot 106 est solidarisé au substrat 102 par l'intermédiaire d'un cordon de scellement 108 qui délimite latéralement une cavité 110 dans laquelle le micro-dispositif 104 est encapsulé. La capot 106 comporte une couche 112 d'un premier matériau correspondant à un substrat aminci dont l'épaisseur est par exemple comprise entre environ 5 µm et 100 µm. Une face 114 de la couche 112 forme une paroi intérieure de la cavité 110, ici une paroi supérieure de la cavité 110. Enfin, des portions de renfort mécanique 116 présentant des propriétés d'absorption et/ou d'adsorption gazeuse et comprenant au moins un matériau getter métallique sont réalisées contre la face 114 de la couche 112, remplissant la double fonction de pompage gazeux et de renfort mécanique du capot 106.

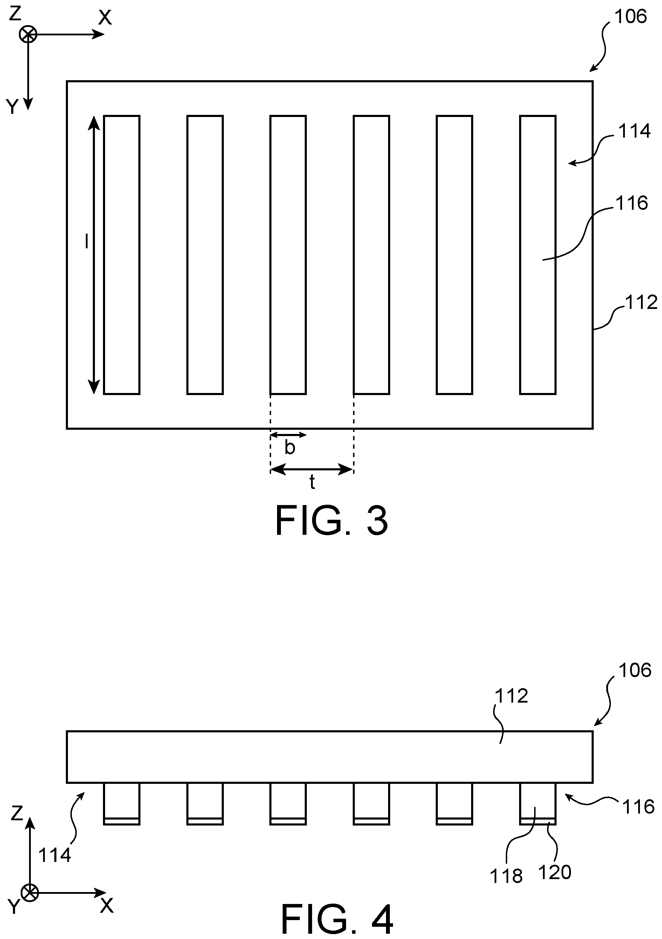

Un premier exemple de réalisation du capot 106 est décrit en liaison avec les figures 2 et 3 représentant respectivement une vue en coupe de profil et une vue de dessous d'une partie du capot 106.

Dans ce premier exemple de réalisation, chacune des portions de renfort mécanique 116 est de forme parallélépipédique rectangle et est disposée contre la face 114 de la couche 112. Ces portions de renfort mécanique 116 sont disposées les unes à côté des autres et parallèlement les unes par rapport aux autres (et sont orientées parallèlement à l'axe Y sur l'exemple représenté sur les figures 2 et 3). Chacune des portions de renfort mécanique 116 a une longueur I (dimension selon l'axe Y) correspondant sensiblement à la largeur de la partie de la face 114 qui forme la paroi supérieure de la cavité 110 (qui dépend notamment des dimensions de la cavité 110 et donc des dimensions du micro-dispositif 104 encapsulé). Les portions de renfort mécanique 116 sont réparties sur toute la longueur de cette partie de la face 114 afin de consolider mécaniquement l'ensemble de la paroi supérieure de la cavité 110. Les parties périphériques de la face 114 qui ne sont pas recouvertes par les portions de renfort mécanique 116 correspondent notamment aux parties de la couche 112 destinées à être en contact avec le cordon de scellement 108. Chacune des portions de renfort mécanique 116 a une largeur b (dimension selon l'axe X), ces portions 116 étant en outre disposées les unes à côté des autres avec une période t, cette période étant égale à la somme de la largeur b et de l'espace séparant deux portions de renfort mécanique. Enfin, la couche 112 a une épaisseur h (dimension selon l'axe Z), et le capot 106 a une épaisseur globale H égale à la somme de l'épaisseur h de la couche 112 et de l'épaisseur des portions de renfort mécanique 116 (chaque portion de renfort mécanique 116 a donc une épaisseur égale à H-h).

Afin que les portions de renfort mécanique 116 remplissent à la fois leur rôle de renfort mécanique du capot 106 et de pompage gazeux, ces portions 116 sont réalisées, dans ce premier exemple de réalisation, avec un matériau getter métallique dont le module d'Young est supérieur ou égal à celui du premier matériau de la couche 112 (ce premier matériau correspondant ici à du silicium, dont le module d'Young est égal à environ 110 GPa). Ainsi, dans ce premier exemple de réalisation, chacune des portions de renfort mécanique 116 comporte une portion d'un ou plusieurs des matériaux suivants : chrome, molybdène, tantale, tungstène, vanadium, cobalt, fer, manganèse, nickel, cuivre, ruthénium, platine. Lorsque la couche 112 est à base de silice, et comporte par exemple du verre tel que du verre de type Pyrex®, dont le module d'Young est égal à 70 GPa, ou du SiO₂ déposé (par exemple dans le cas d'un capot formé par dépôt de couche mince), dont le module d'Young est également de 70 GPa, les portions de renfort mécanique 116 peuvent comporter en outre de l'hafnium et/ou du niobium et/ou du titane.

Les portions de renfort mécanique 116 sont avantageusement dimensionnées et positionnées telles qu'un rapport r = h/H soit compris entre environ 0,6 et 0,9, et telles qu'un rapport R = b/t soit supérieur ou égal à environ 0,7. Plus précisément, en considérant un paramètre M = E(X)/E(Y), avec E(X) le module d'Young du matériau des portions de renfort mécanique 116 et E(Y) le module d'Young du premier matériau de la couche 112, un paramètre O = H/b et un rapport de moments d'inertie Dy/D = 2, avec Dy correspondant au moment d'inertie du capot 106 (couche du premier matériau 112 + portions de renfort mécanique 116) et D correspondant au moment d'inertie de la couche du premier matériau 112 seule, c'est-à-dire sans les portions de renfort mécanique 116, les rapports r et R peuvent être choisis comme indiqués dans le tableau ci-dessous :

| M | O | r | R |
|---|---|---|---|
| 2 | 2 | [0,6 - 0,8] | ≥ 0,8 |
| 2 | 5 | [0,6 - 0,8] | ≥ 0,7 |
| 3 | 2 | [0,6 - 0,8] | ≥ 0,7 |
| 3 | 5 | [0,6 - 0,9] | ≥ 0,8 |

A titre d'exemple, pour une couche 112 comportant du silicium et des portions de renfort mécanique 116 comportant du tungstène, les portions de renfort mécanique 116 peuvent être dimensionnées telles que :

| O | H (µm) | b (µm) | h (µm) | t (µm) | (H-h) (µm) |
|---|---|---|---|---|---|
| 2 | 50 | 25 | [30 - 40] | ≤ 35,7 | [10 - 20] |
| 5 | 50 | 10 | [30 - 45] | ≤ 12,5 | [5 - 20] |

Dans le cas d'une couche 112 réalisée par dépôt de couche mince (épaisseur par exemple inférieure ou égale à environ 10 µm) de SiO₂, dont le module d'Young associé est de 70 GPa, les règles de dimensionnement suivantes peuvent être suivies pour la réalisation des portions de renfort mécanique 116 :

| M | O | H (µm) | b (µm) | h (µm) | t (µm) | (H-h) (µm) |
|---|---|---|---|---|---|---|
| 3 | 2 | 10 | 5 | 6-8 | <=7.14 | 2-4 |
| 3 | 5 | 5 | 2.5 | 3-4 | <=3.12 | 2-3 |

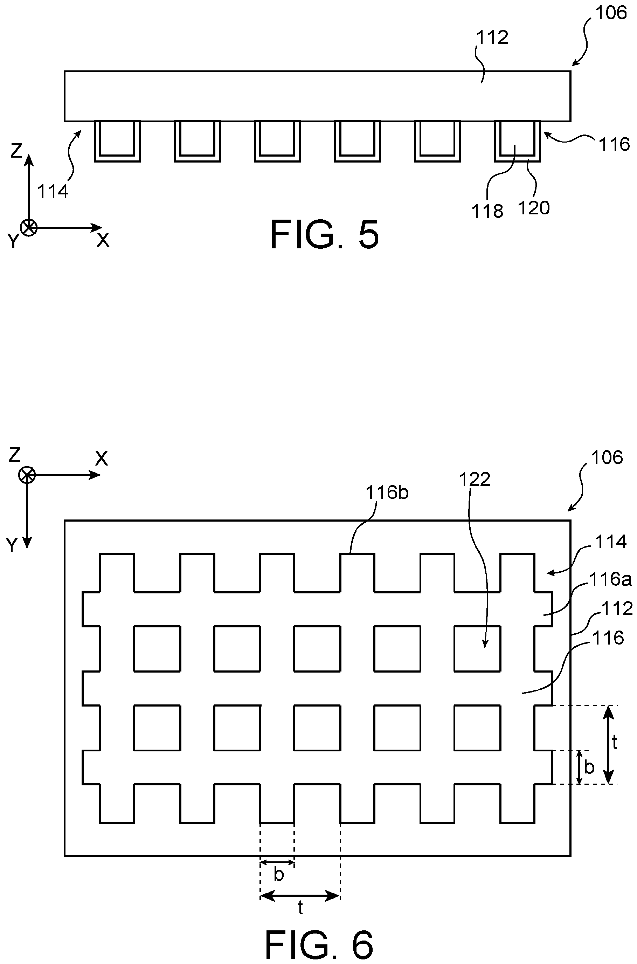

En variante, les portions de renfort mécanique 116 peuvent comporter plusieurs couches, ou parties, de différents matériaux superposées les unes au-dessus des autres. Ainsi, sur la figure 4, chacune des portions de renfort mécanique 116 comporte une première couche de matériau 118 et une deuxième couche de matériau 120 disposées l'une au-dessus de l'autre telles la première couche 118 soit disposée entre la face 114 de la couche 112 et la deuxième couche 120. Selon une autre variante de réalisation représentée sur la figure 5, pour chacune des portions de renfort mécanique 116, la deuxième couche 120 recouvre complètement la première couche 118. Selon ces variantes, la deuxième couche 120 peut comporter un ou plusieurs matériaux getters tels que ceux précédemment décrits, ou encore du titane et/ou du zirconium ou un alliage à base de titane ou de zirconium présentant un effet getter.

Dans chacune de ces portions de renfort mécanique 116 formée de plusieurs couches de différents matériaux, il est possible d'utiliser un matériau getter métallique pour réaliser la couche supérieure (la couche 120 sur les exemples des figures 4 et 5), comme l'un de ceux précédemment décrits, et d'utiliser un matériau ne présentant pas de propriétés d'absorption et/ou d'adsorption gazeuse pour réaliser le reste des portions de renfort mécanique 116, c'est-à-dire la couche 118 sur les exemples des figures 4 et 5. Ainsi, il est possible de faire appel, pour la réalisation des couches 118, à des matériaux pouvant être déposés avec des épaisseurs plus importantes que les matériaux getter métalliques, ce qui permet de réaliser des portions de renfort mécanique 116 d'épaisseur plus importante, et donc d'améliorer la consolidation mécanique du capot 106 obtenue grâce aux portions de renfort mécanique 116.

Dans le cas d'une couche 112 de silicium, la couche 118 peut comporter un ou plusieurs métaux tels que du chrome, du molybdène, du tantale, du tungstène, du vanadium, du cobalt, du fer, du manganèse, du nickel, du cuivre, du ruthénium ou du platine. Dans le cas d'une couche 112 à base de silice et comprenant par exemple du SiO₂, outre les matériaux précédemment mentionnés, il est possible que la couche 118 comporte de l'hafnium et/ou du niobium et/ou du titane.

En variante, chacune des portions de renfort mécanique 116 peut comporter plus de deux couches de matériaux différents et/ou comporter au moins deux couches de matériaux getter métalliques, notamment différents l'un de l'autre.

La figure 6 représente une vue de dessous d'un deuxième exemple de réalisation du capot 106. Les portions de renfort mécanique 116 sont ici réalisées sous la forme d'un maillage, c'est-à-dire sous la forme de portions se croisant en formant une grille. Des parties 122 de la face 114 non recouvertes par les portions 116, formant des parties de la paroi supérieure de la cavité 110 et dont la forme correspond aux mailles du maillage réalisé par les portions de renfort mécanique 116, sont ici de forme carrée (dans le plan de la face 114). Par rapport au premier exemple de réalisation précédemment décrit en liaison avec les figures 2 et 3, ce deuxième exemple de réalisation des portions de renfort mécanique 116 permet d'obtenir un meilleur renfort mécanique du capot 106 et/ou de relâcher la contrainte liée au paramètre t précédemment décrit car, pour un même renfort mécanique, la période t avec laquelle les portions 116 sont disposées dans ce deuxième exemple de réalisation est supérieure à la période t avec laquelle les portions 116 sont disposées dans le premier exemple de réalisation. Ainsi, pour un même renfort mécanique du capot 106, il est donc possible, avec ce deuxième exemple de réalisation, d'augmenter l'espacement entre les portions de renfort mécanique 116.

Sur l'exemple représenté sur la figure 6, des premières portions de renfort mécanique 116a sont de forme parallélépipédique rectangle et disposées parallèlement à l'axe X, et des deuxièmes portions de renfort mécanique 116b sont de forme parallélépipédique rectangle et disposées parallèlement à l'axe Y et croisent perpendiculairement les premières portions de renfort mécanique 116a. En variante, les parties 122 de la face 114 non recouvertes par les portions de renfort mécanique 116 peuvent être de forme rectangulaire, hexagonale, ou d'une toute autre forme. Les valeurs des rapports r et R précédemment décrites s'appliquent également à ce deuxième exemple de réalisation. De plus, les variantes de réalisation des portions de renfort mécanique 116 sous la forme de plusieurs couches de différents matériaux précédemment décrites peuvent s'appliquer à ce deuxième exemple de réalisation du capot 106.

Lorsque les portions de renfort mécanique 116 comportent plusieurs couches de matériaux superposées, le matériau utilisé pour réaliser la couche inférieure (la couche 118 sur les exemples des figures 4 et 5) se trouvant sous la couche supérieure comprenant un matériau getter métallique (la couche 120 sur les exemples des figures 4 et 5) peut être choisi tel qu'il modifie la température d'activation thermique du matériau getter de la couche supérieure. Ainsi, il est par exemple possible d'augmenter la température d'activation thermique du matériau getter de la couche supérieure selon la température de fusion du matériau de la sous-couche, comme décrit par exemple dans le document FR 2 922 202. Par exemple, pour une couche supérieure en titane et/ou en zirconium, il est possible d'avoir une température d'activation thermique du matériau de cette couche supérieure comprise entre environ 250°C et 375°C en utilisant, pour réaliser la couche inférieure, un ou plusieurs métaux tels que du W, du Ta, du Mo, du Ru, du Cr, du Pt, du Fe, du Co, du Ni, du Mn, ou du Cu, ces métaux étant énumérés ici selon un ordre croissant de la température d'activation thermique pouvant être obtenue. Avec une telle configuration, il est possible de réaliser un compromis entre la température du cycle de scellement qui est inférieure à la température d'activation thermique, et la protection du dispositif encapsulé.

Les portions de renfort mécanique 116 peuvent également permettre de pré-contraindre le capot 106 grâce à la formation de contraintes intrinsèques en tension dans les portions de renfort mécanique 116. Plusieurs procédés de dépôts de matériaux utilisés en microélectronique et appliqués ici à la réalisation des portions de renfort mécanique 116 permettent d'obtenir cela (pulvérisation cathodique, durcissement par polarisation du substrat, etc., afin de contrôler la densité et la microstructure du dépôt). Ainsi, il est par exemple possible de « pré-déformer » le capot 106, lors de sa réalisation, dans le sens opposé à une déformation que le capot 106 subira lors d'une étape ultérieure telle qu'une étape de surmoulage.

De même, lorsque les portions de renfort mécanique 116 comportent plusieurs couches de matériaux superposées, des matériaux présentant des coefficients de dilatation différents (par exemple pour réaliser les couches 118 et 120) peuvent être utilisés pour la réalisation des portions de renfort mécanique 116. Chaque portion de renfort mécanique 116 forme alors un bilame qui, sous l'action de la température et notamment lors des opérations d'assemblage, va accroître la résistance mécanique du capot 106. En effet, le bilame qui est non déformé à température ambiante va pouvoir s'opposer aux contraintes extérieures agissant sur le capot 106. Pour réaliser un tel bilame, un couple de matériaux est choisi pour réaliser les couches 118 et 120 des portions de renfort mécanique 116 de façon à ce que le matériau de plus fort coefficient de dilation thermique soit déposé contre la face 114 de la couche 112, le second élément du bilame (le matériau getter) qui comporte un plus faible coefficient de dilatation thermique étant déposé sur ce premier matériau. Un tel effet bilame peut par exemple être obtenu en réalisant la première couche 118 à base de nickel et en réalisant la deuxième couche 120 à base de titane. En outre, l'utilisation du nickel pour la réalisation de la première couche 118 a également pour avantage d'être facilement déposable par dépôt électrolytique (ECD) jusqu'à des épaisseurs d'environ 10 µm à 20 µm. Un tel couple de matériaux permet donc de répondre aux règles de dessin définies précédemment.

En variante, un effet bilame à température ambiante permettant d'exercer une force dirigée vers l'extérieur de la cavité 110 peut être provoqué en choisissant un couple de matériaux tels que le matériau déposé contre la face 114 ait le coefficient de dilation thermique le plus faible parmi ces deux matériaux, sur lequel est déposé le getter à une température supérieure à celle du premier dépôt. A titre d'exemple, pour renforcer un capot en silicium, il est possible de déposer tout d'abord sur le capot du tungstène et/ou du molybdène et/ou du chrome, puis de déposer ensuite du titane et/ou du zirconium. Pour renforcer un capot en couche mince, les mêmes matériaux peuvent être utilisé, le matériau à effet getter étant déposé en premier sur la couche sacrificielle, à une température supérieure à celle utilisée pour réaliser le second dépôt.

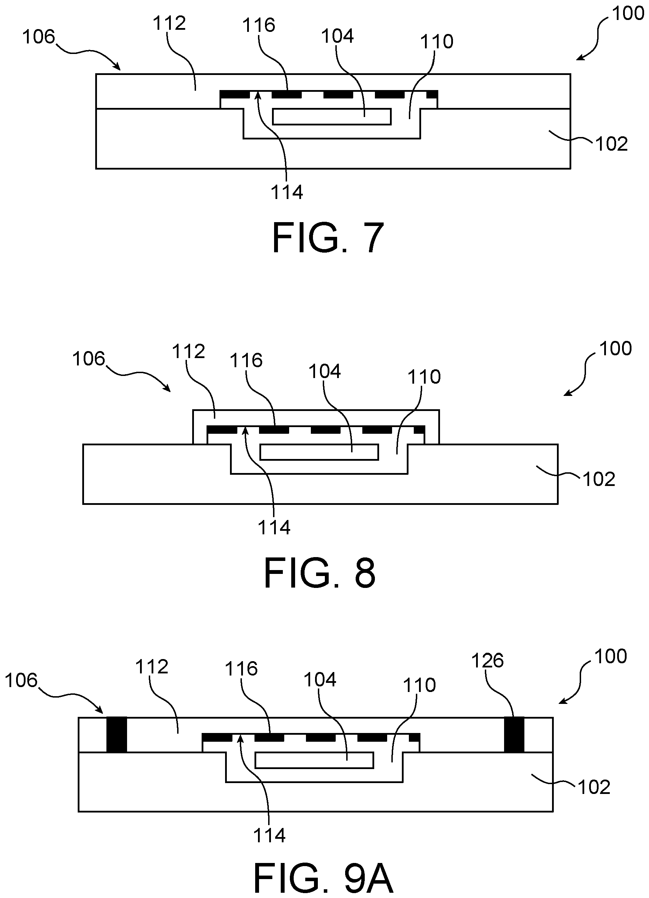

La figure 7 représente une vue en coupe de la structure d'encapsulation 100 selon une variante du premier mode de réalisation. Par rapport à la structure d'encapsulation 100 précédemment décrite en liaison avec la figure 1, le capot 106 et le substrat 102 sont solidarisés directement l'un contre l'autre, sans le cordon de scellement 108, par exemple par collage anodique ou eutectique selon la nature des matériaux de la couche 112 et du substrat 102. Un collage direct silicium-silicium est par exemple réalisé lorsque la couche 112 et le substrat 102 comportent tous les deux du silicium. De manière alternative, un scellement anodique est par exemple réalisé lorsque la couche 112 comporte du verre et que le substrat 102 comporte du silicium. Dans cette variante du premier mode de réalisation, du fait que les parois latérales de la cavité 110 ne sont pas formées par un cordon de scellement, au moins une partie de la cavité 110 est formée en gravant une partie de l'épaisseur de la couche 112, le fond de la gravure formant la paroi 114. Les portions de renfort mécanique 116 sont disposées au niveau de cette paroi gravée. Lorsque la couche 112 du capot 106 est ainsi gravée, les bords latéraux des portions de renfort mécanique 116 peuvent être en contact avec les flancs latéraux de cette partie gravée de la couche 112, afin de former un appui mécanique supplémentaire pour les portions de renfort mécanique 116.

La figure 8 représente une vue en coupe de la structure d'encapsulation 100 selon un deuxième mode de réalisation. Par rapport à la structure d'encapsulation 100 précédemment décrite en liaison avec les figures 1 à 7, la couche 112 du capot 106 ne correspond pas à un substrat aminci, mais à une ou plusieurs couches minces déposées de type PCM, par exemple d'épaisseur inférieure ou égale à environ 5 µm. Les portions de renfort mécanique 116 sont disposées sur la face 114 de la couche 112 formant la paroi sommitale intérieure de la cavité 110.

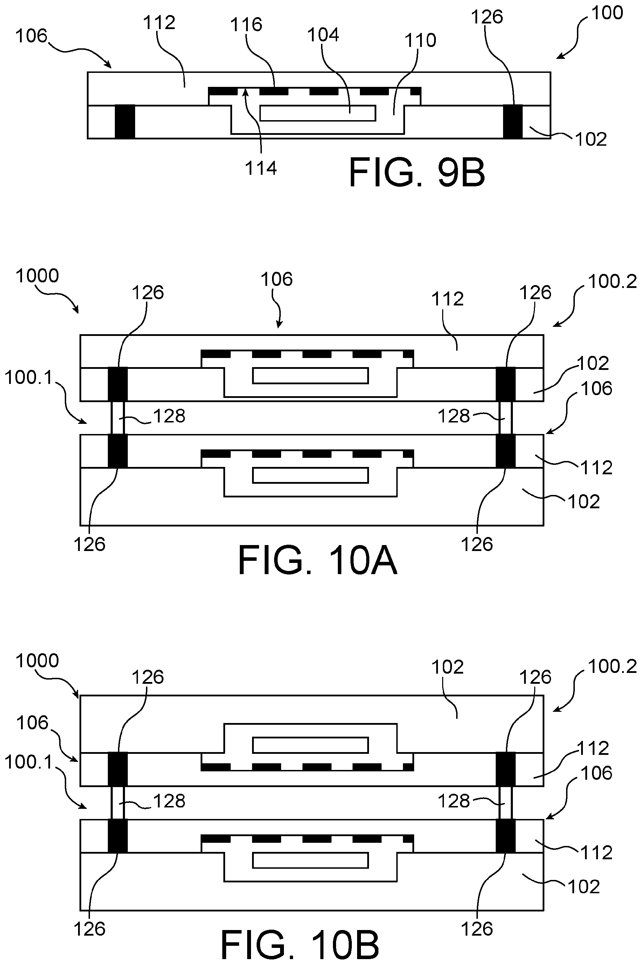

Comme représenté sur les figures 9A et 9B, il est possible que le la couche 112 et/ou le substrat 102 soient traversés par des connecteurs électriques, ou vias électriquement conducteurs, 126. Ces vias 126 peuvent par exemple être reliés électriquement au micro-dispositif 104 encapsulé et former ainsi des accès électriques d'entrée et/ou de sortie de ce micro-dispositif 104. De tels vias électriquement conducteurs peuvent être réalisés dans une structure d'encapsulation dont le capot est réalisé par dépôt de couches minces ou par report de substrat.

Plusieurs structures d'encapsulation similaires à celles représentées sur les figures 9A et 9B peuvent être superposées les unes au-dessus des autres et reliées électriquement entre elles par l'intermédiaire de leurs vias 126 et d'interconnexions électriques reliant électriquement entre eux ces vias 126. Les figures 10A et 10B sont des vues en coupe d'un dispositif microélectronique 1000 comprenant deux structures d'encapsulation 100.1 et 100.2 superposées et reliées électriquement entre elles. Sur l'exemple de la figure 10A, les vias 126 traversant le capot 106 d'une première structure d'encapsulation 100.1 sont reliés électriquement aux vias 126 traversant le substrat 102 d'une deuxième structure d'encapsulation 100.2 par l'intermédiaire d'interconnexion électriques 128 réalisées entre les deux structures d'encapsulation 100.1 et 100.2. Sur l'exemple de la figure 10B, les vias 126 traversant le capot 106 d'une première structure d'encapsulation 100.1 sont reliés électriquement aux vias 126 traversant le capot 106 d'une deuxième structure d'encapsulation 100.2 par l'intermédiaire d'interconnexions électriques 128. Dans ces deux cas, il est possible que la première structure d'encapsulation 100.1 et/ou la deuxième structure d'encapsulation 100.2 comporte des vias électriquement conducteurs traversant le substrat 102 et le capot 106 d'une même structure d'encapsulation. De manière générale, le dispositif 1000 peut comporter plusieurs structures d'encapsulation dans lesquelles sont packagés des micro-dispositifs ayant des fonctions différentes (gyromètre, accéléromètre, etc.).

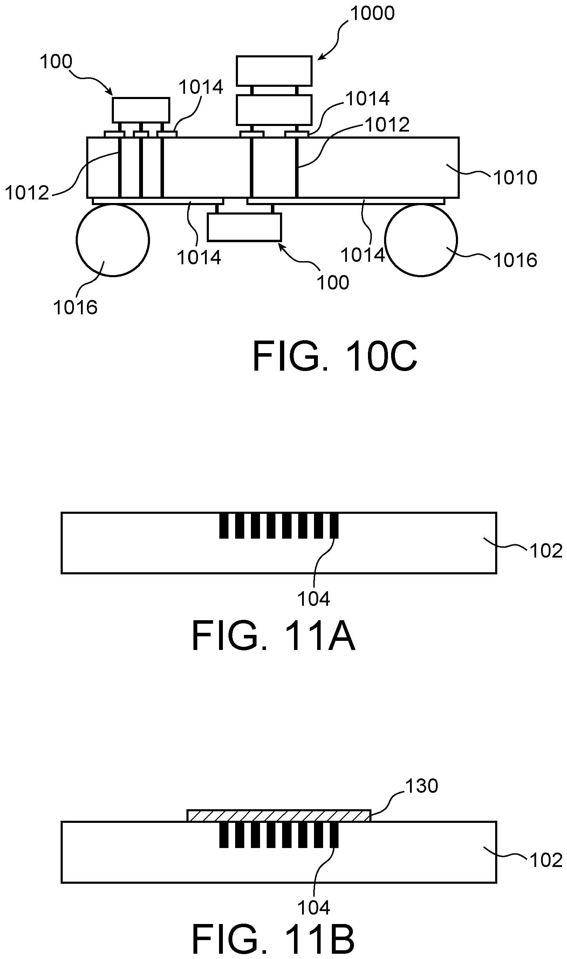

Comme représenté sur la figure 10C, une ou plusieurs structures d'encapsulation 100 et/ou un ou plusieurs dispositifs microélectroniques 1000, formant des puces électroniques, peuvent être connectés sur une plateforme servant à accueillir plusieurs puces, éventuellement sur ses deux faces principales, et à les relier électriquement entre elles. Sur la figure 10C, cette plateforme est formée par un interposeur 1010, par exemple en silicium ou en verre. Cet interposeur 1010 comporte des connecteurs électriques traversants 1012 de type TSV (« Trough Silicon Via ») lorsque l'interposeur 1010 est en silicium, ou de type TGV (« Trough Glass Via ») lorsque l'interposeur 1010 est en verre. Ces connecteurs sont reliés électriquement par un réseau de lignes conductrices de reroutage (« Redistribution Layers, ou RDL), référencées 1014 sur la figure 10C et formées sur l'une ou les deux faces de l'interposeur 1010. Les dispositifs microélectroniques 1000 et/ou les structures d'encapsulation 100 peuvent être juxtaposés et/ou superposés les uns au-dessus des autres d'un côté ou des deux côtés de l'interposeur 1010. Des billes fusibles 1016 peuvent être réalisées par exemple d'un côté de l'interposeur 1010 et peuvent être reliées électriquement à une ou plusieurs des lignes de reroutage.

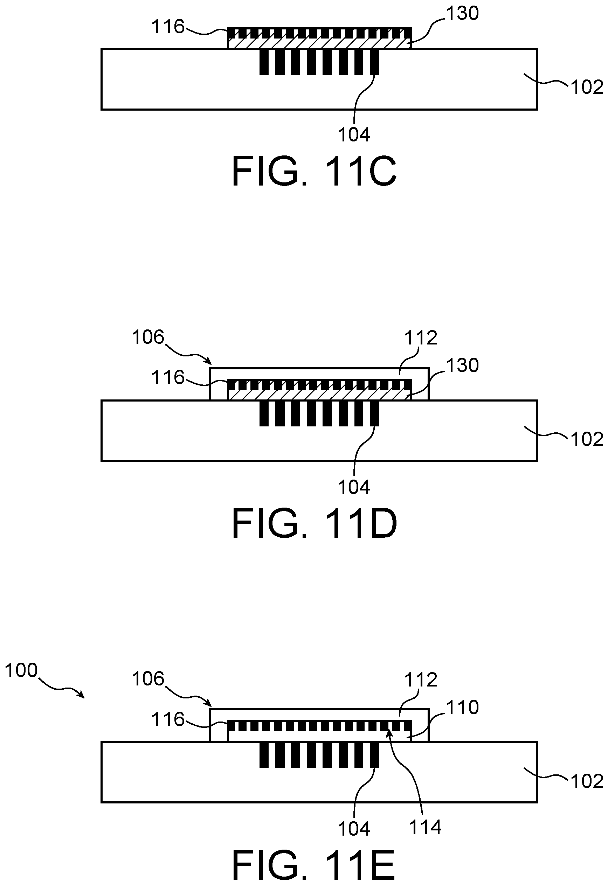

Les figures 11A à 11E représentent les étapes d'un procédé de réalisation de la structure d'encapsulation 100 selon le deuxième mode de réalisation, c'est-à-dire dans laquelle le capot 106 comporte une couche 112 correspondant à une ou plusieurs couches minces formées par dépôt.

Comme représenté sur la figure 11A, le micro-dispositif 104 est tout d'abord réalisé dans le substrat 102 par la mise en œuvre d'étapes classiques de la microélectronique (dépôt, photolithographie, gravure, etc.).

Une couche sacrificielle est ensuite déposée sur le substrat 102, en recouvrant notamment le micro-dispositif 104. Cette couche sacrificielle est ensuite mise en forme, par exemple par gravure, afin qu'une portion restante 130 de matériau sacrificiel, disposée sur le micro-dispositif 104, occupe un volume correspondant à celui de la cavité 110 dans laquelle le micro-dispositif 104 est destiné à être encapsulé (figure 11B).

Comme représenté sur la figure 11C, les portions de renfort mécanique 116 sont ensuite réalisées sur la portion de matériau sacrificiel 130.

Pour cela, les portions de renfort mécanique 116 peuvent être directement réalisées sur la portion de matériau sacrificiel 130 par dépôt d'un ou plusieurs matériaux selon que les portions de renfort mécanique 116 comportent une ou plusieurs couches de matériaux superposées. Le ou les matériaux déposés peuvent ensuite être structurés par une photolithographie puis une gravure chimique, formant les portions de renfort mécanique 116. Il est possible de déposer ensuite, entre les portions de renfort mécanique 116, un matériau sacrificiel, par exemple de nature similaire à celui de la portion 130, qui sera gravé simultanément avec la portion 130 lors de la formation ultérieure de la cavité 110. Ce matériau sacrificiel peut dans ce cas être déposé puis planarisé avec arrêt sur les portions de renfort mécanique 116.

En variante, il est possible de graver dans la portion de matériau sacrificiel 130 des emplacement des portions de renfort mécanique 116, puis de déposer le ou les matériaux de ces portions de renfort mécanique 116 dans les emplacements gravés.

Lorsque l'épaisseur des portions de renfort mécanique 116 est inférieure ou égale à environ 2 µm, le matériau de ces portions 116 peut être déposé directement par PVD (dépôt physique en phase vapeur) sur la portion de matériau sacrificiel 130. L'épaisseur des portions de renfort mécanique 116 peut être augmentée en mettant en œuvre plusieurs dépôts PVD successifs, par exemple de différents matériaux.

Lorsque l'épaisseur des portions de renfort mécanique 116 est supérieure à environ 2 µm, il est possible de déposer tout d'abord une couche de germination par PVD, puis de déposer le ou les matériaux des portions de renfort mécanique 116 par ECD. Ainsi, il est par exemple possible de réaliser un premier dépôt de titane et de nickel, d'épaisseur comprise entre environ 10 nm et plusieurs centaines de nanomètres, par PVD à travers un masque de résine, puis de déposer du nickel par électrolyse à travers le masque sur une épaisseur par exemple comprise entre 1 micron et plusieurs dizaines de microns. Lorsque l'épaisseur du matériau des portions de renfort mécanique 116 déposé par ECD est importante, par exemple supérieure à environ quelques dizaines de microns, le dépôt ECD est avantageusement prolongé au-delà de l'épaisseur du masque de résine. En effet, une fois cette hauteur dépassée, le matériau déposé croit également latéralement, conférant ainsi aux portions de renfort mécanique 116 un profil en forme de « champignon », c'est-à-dire comportant une partie supérieure plus large que le reste de la portion, qui limite les espaces entre les portions de renfort mécanique 116 qui sont destinés à être bouchés par la couche 112 qui est déposée ensuite. Dans l'exemple ci-dessus, le premier dépôt de titane forme la couche supérieure 120 des portions de renfort mécanique 116, alors que le nickel déposé forme la couche 118 de ces portions de renfort mécanique 116. L'épaisseur de titane déposée est avantageusement supérieure à environ 100 nm. Le masque de résine est ensuite retiré et les portions de la couche de germination se trouvant entre les portions de renfort mécanique 116 sont alors gravées avec arrêt sur la portion de matériau sacrificiel 130.

Comme représenté sur la figure 11D, la couche 112 est alors déposée, par exemple via un dépôt PECVD (dépôt chimique en phase vapeur assisté par plasma) de nitrure de silicium et/ou d'oxyde de silicium. L'utilisation de nitrure de silicium peut servir à renforcer la couche d'encapsulation.

Enfin, la couche sacrificielle 130 est gravée, par exemple à travers une ouverture réalisée à travers la couche 112, formant ainsi la cavité 110 dans laquelle le micro-dispositif 104 est encapsulé et dont la paroi supérieure est formée par la face 114 de la couche 112 contre laquelle se trouvent les portions de renfort mécanique 116.

En variante, il est possible de réaliser un renforcement mécanique supplémentaire du capot 106 en déposant, sur la couche 112 (sur la face de la couche 112 opposée à la face 114), une couche continue par exemple en métal et par PVD avec une épaisseur d'environ 1 µm, ou par ECD pour obtenir une épaisseur de matériau pouvant aller de quelques microns à plusieurs dizaines de microns. Cette couche continue est avantageusement déposée également en périphérie du capot 106, sur le substrat 102, ce qui permet d'améliorer la rigidité de cette couche compte tenu d'un effet de voûte obtenue avec une telle couche.

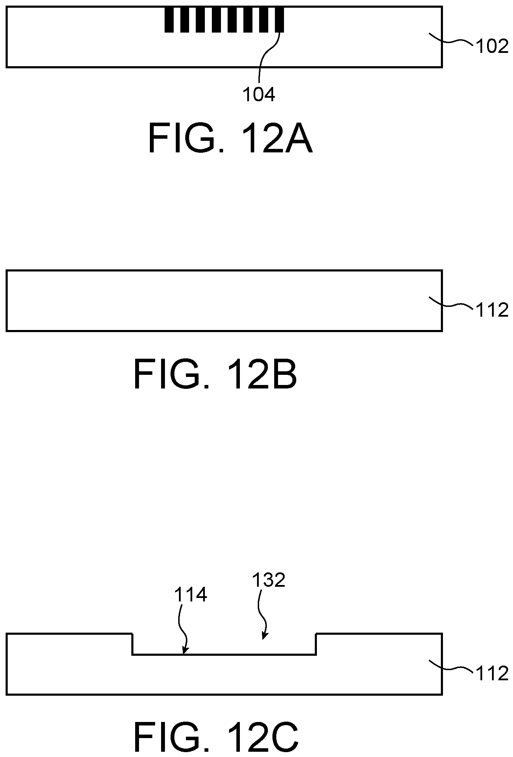

Les figures 12A à 12F représentent les étapes d'un procédé de réalisation de la structure d'encapsulation 100 selon le premier mode de réalisation, c'est-à-dire dans laquelle le capot 106 est réalisé par report de substrat.

Comme représenté sur la figure 12A, le micro-dispositif 104 est tout d'abord réalisé dans le substrat 102 par la mise en œuvre d'étapes classiques de la microélectronique (dépôt, photolithographie, gravure, etc.).

Le capot 106 est ensuite réalisé à partir d'une couche 112 correspondant à un substrat, ou wafer, par exemple de verre ou de silicium (figure 12B).

Un creux 132 destiné à former au moins une partie de la cavité 110 de la structure d'encapsulation 100 est gravée dans la couche 112, révélant ainsi la face 114 de la couche 112 qui formera la paroi supérieure de la cavité 110 (figure 12C).

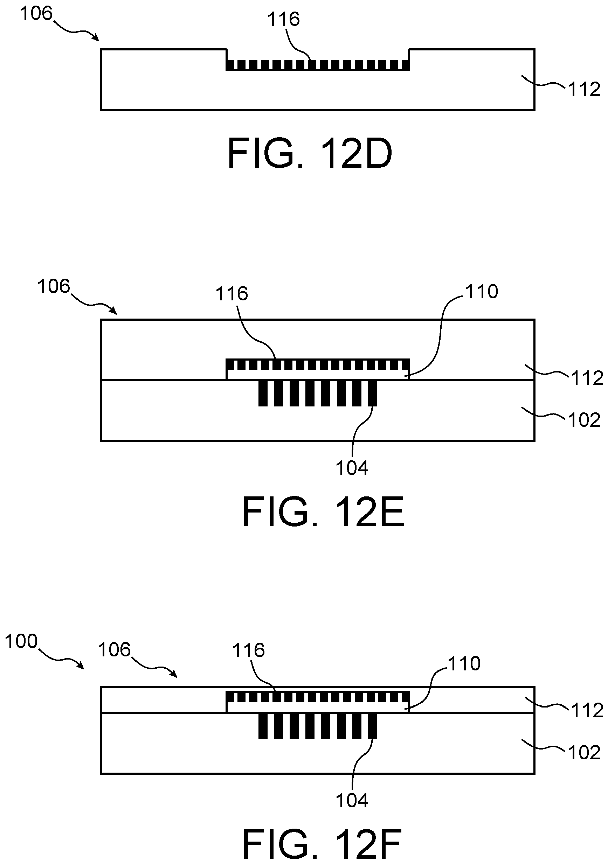

Les portions de renfort mécanique 116 sont ensuite réalisées contre la face 114, dans le creux 132 (figure 12D). Ces portions de renfort mécanique 116 sont par exemple réalisées via un premier dépôt PVD d'une couche d'accroche de titane ou de chrome d'épaisseur égale à quelques dizaines de nanomètres, puis le dépôt d'une deuxième couche barrière en nickel d'épaisseur égale à quelques centaines de nanomètres, et enfin le dépôt d'une troisième couche d'Au d'épaisseur égale à quelques dizaines de nanomètres. Ces trois couches déposées forment la couche de germination, correspondant à la première couche 118. Le matériau de la deuxième couche 120 des portions de renfort mécanique 116 est ensuite déposé par ECD avec une épaisseur telle que décrite précédemment, allant de plusieurs microns à plusieurs dizaines de microns.

Ce dépôt est par exemple réalisé à travers des motifs réalisés dans un film photosensible disposé au-dessus de la couche de germination. Plusieurs couches de matériaux peuvent être déposées à travers ce film, en terminant notamment par le dépôt d'un matériau getter métallique afin que celui-ci se retrouve exposé dans la cavité 110. Le ou les matériaux déposés entre les portions 116, sur le film photosensible, peuvent être retirés simultanément avec ce film par lift-off. Les parties de la couche de germination se trouvant entre les portions de renfort mécanique 116 sont ensuite gravées, par exemple par voie chimique. Préalablement à cette gravure, il est possible de protéger les portions de renfort mécanique 116, et notamment le matériau getter, par une nitruration ou une oxydation par voie sèche de ce ou ces matériaux, limitant ainsi l'attaque chimique de ce ou ces matériaux lors de la gravure chimique de la couche de germination.

En variante, lorsque le matériau des portions de renfort mécanique 116 n'est pas déposable par ECD, ce matériau peut être déposé par PVD. Dans ce cas, les différentes couches des portions de renfort mécanique 116 sont tout d'abord déposées, puis les portions de renfort mécanique 116 sont obtenues par la mise en forme de ces couches, par exemple via une photolithographie et lift-off ou une gravure chimique de ces couches.

Le capot 106 ainsi obtenu est ensuite solidarisé au substrat 102, directement ou par l'intermédiaire d'un cordon de scellement selon la nature des matériaux de la couche 112 et du substrat 102. Le micro-dispositif 104 se retrouve alors encapsulé dans la cavité 110 dans laquelle se trouvent les portions de renfort mécanique 116 au niveau de la paroi supérieure de la cavité 110 (figure 12E).

Comme représenté sur la figure 12F, la structure d'encapsulation 100 est achevée en réalisant un amincissement de la couche 112.

En variante des procédés précédemment décrits en liaison avec les figures 11A à 11E et 12A à 12F, le capot 106, comprenant la couche 112 et les portions de renfort mécanique 106, peut être réalisé tout d'abord dans un moule correspondant par exemple à un substrat gravé de verre ou de silicium. Pour cela, le substrat destiné à servir de moule est tout d'abord gravé selon la forme souhaitée du capot 106. Une couche de polymère, par exemple du PTFE, est déposée sur la face gravée du moule. Les couches destinées à former le capot 106, c'est-à-dire la couche 112 et la ou les couches des portions de renfort mécanique 116, sont ensuite déposées sur la couche de polymère, par exemple via des étapes similaires à celles précédemment décrites en liaison avec la figure 12D. Le capot 106 réalisé dans le moule est alors assemblé au substrat comprenant le micro-dispositif à encapsuler en reportant le moule sur le substrat et solidarisé au substrat, par exemple via un collage polymère, ou par fusion eutectique ou encore par thermocompression. Le moule est enfin désolidarisé du capot 106 via la suppression de la couche de polymère afin de former la structure d'encapsulation. Des détails de mise en œuvre d'un tel procédé sont par exemple décrits dans les documents FR 2 934 580 et US 7 897 436.

## Revendications

1. Structure d'encapsulation (100) d'au moins un micro-dispositif (104) réalisé sur et/ou dans un substrat (102) et disposé dans au moins une cavité (110) formée entre le substrat (102) et un capot (106) solidarisé au substrat (102), dans laquelle le capot (106) comporte au moins :
- une couche (112) d'un premier matériau dont une face (114) forme une paroi intérieure de la cavité (110), et
- des portions de renfort mécanique (116) solidarisées au moins à ladite face (114) de la couche du premier matériau (112), recouvrant en partie ladite face (114) de la couche du premier matériau (112) et présentant des propriétés d'absorption et/ou d'adsorption gazeuse,
**caractérisée en ce que** ces portions de renfort mécanique (116) comprennent au moins un deuxième matériau dont le module d'Young est supérieur à celui du premier matériau,
et **en ce que** chacune des portions de renfort mécanique (116) comporte au moins une première couche (118) du deuxième matériau et au moins une deuxième couche (120) d'un troisième matériau getter métallique telles que la première couche (118) du deuxième matériau soit disposée entre la couche du premier matériau (112) et la deuxième couche (120) du troisième matériau et/ou soit recouverte par la deuxième couche (120) du troisième matériau.

2. Structure d'encapsulation (100) selon la revendication 1, dans laquelle le deuxième matériau est un matériau getter métallique.

3. Structure d'encapsulation (100) selon l'une des revendications précédentes, dans laquelle chacune des portions de renfort mécanique (116) comporte un empilement de couches (118, 120) dont au moins deux desdites couches (118, 120) forment un bilame exerçant sur le capot (106) une force dirigée vers l'extérieur de la cavité (110).

4. Structure d'encapsulation (100) selon l'une des revendications précédentes, dans laquelle le premier matériau est à base de Si et/ou de silice et/ou de nitrure de silicium, et le deuxième matériau est à base de Cr et/ou de Ti et/ou de Co et/ou de Fe et/ou de Mn et/ou de Mo et/ou de Ta et/ou de V et/ou de W et/ou de Pd et/ou de Rh et/ou de Pt et/ou de Ru et/ou de Zr.

5. Structure d'encapsulation (100) selon l'une des revendications 2 à 4, dans laquelle le ou les matériaux getter métalliques sont à base de Cr et/ou de Ti et/ou de Co et/ou de Fe et/ou de Mn et/ou de Mo et/ou de Ta et/ou de V et/ou de W et/ou de Pd et/ou de Rh et/ou de Pt et/ou de Ru et/ou de Zr.

6. Structure d'encapsulation (100) selon l'une des revendications précédentes, dans laquelle chacune des portions de renfort mécanique (116) est de forme sensiblement parallélépipédique rectangle, les portions de renfort mécanique (116) étant disposées sensiblement parallèlement les unes par rapport aux autres.

7. Structure d'encapsulation (100) selon l'une des revendications 1 à 5, dans laquelle les portions de renfort mécanique (116) forment un maillage sur ladite face (114) de la couche du premier matériau (112).

8. Structure d'encapsulation (100) selon l'une des revendications précédentes, dans laquelle un rapport r = h/H est compris entre environ 0,6 et 0,9, et un rapport R = b/t est supérieur ou égal à environ 0,7, avec :
h : épaisseur de la couche du premier matériau (112) ;
H : somme de h et de l'épaisseur d'une des portions de renfort mécanique (116) ;
b : largeur d'une des portions de renfort mécanique (116) ;
t : période avec laquelle les portions de renfort mécanique (116) sont disposées sur la couche du premier matériau (112).

9. Structure d'encapsulation (100) selon l'une des revendications précédentes, comportant en outre des vias électriquement conducteurs (126) réalisés à travers l'épaisseur du substrat (102) et/ou de la couche du premier matériau (112), à côté de la cavité (110).

10. Dispositif microélectronique (1000) comportant au moins deux structures d'encapsulation (100.1, 100.2) selon la revendication 9 disposées l'une au-dessus de l'autre, dans lequel au moins un via électriquement conducteur (126) d'une première (100.1) des deux structures d'encapsulation est relié électriquement à au moins un via électriquement conducteur (126) d'une deuxième (100.2) des deux structures d'encapsulation directement ou par l'intermédiaire d'un interposeur (1010).

11. Procédé d'encapsulation d'au moins un micro-dispositif (104), comportant au moins les étapes de :
- réalisation du micro-dispositif (104) sur et/ou dans un substrat (102) ;
- réalisation de portions de renfort mécanique (116) solidarisées à au moins une face (114) d'une couche d'un premier matériau (112), recouvrant en partie ladite face (114) de la couche du premier matériau (112) et présentant des propriétés d'absorption et/ou d'adsorption gazeuse, la couche du premier matériau (112) et les portions de renfort mécanique (116) formant un capot (106) ;
- solidarisation du capot (106) au substrat (102) telle que le micro-dispositif (104) soit encapsulé dans une cavité (110) formée entre le capot (106) et le substrat (102) ;
**caractérisé en ce que** les portions de renfort mécanique (116) comprennent au moins un deuxième matériau dont le module d'Young est supérieur à celui du premier matériau, et **en ce que** chacune des portions de renfort mécanique (116) est réalisée au moins par un dépôt d'une première couche (118) du deuxième matériau et d'une deuxième couche (120) d'un troisième matériau getter métallique telles que la première couche (118) du deuxième matériau soit disposée entre la couche du premier matériau (112) et la deuxième couche (120) du troisième matériau et/ou soit recouverte par la deuxième couche (120) du troisième matériau.

12. Procédé d'encapsulation d'au moins un micro-dispositif (104), comportant au moins les étapes de :
- réalisation du micro-dispositif (104) sur et/ou dans un substrat (102) ;
- réalisation d'une portion de matériau sacrificiel (130) au moins sur le micro-dispositif (104) et telle que le volume occupé par la portion de matériau sacrificiel (130) correspond à au moins une partie d'un volume d'une cavité (110) dans laquelle le micro-dispositif (104) est destiné à être encapsulé ;
- réalisation de portions de renfort mécanique (116) sur et/ou dans la portion de matériau sacrificiel (130) et présentant des propriétés d'absorption et/ou d'adsorption gazeuse ;
- dépôt d'une couche d'un premier matériau (112) recouvrant au moins les portions de renfort mécanique (116) et la portion de matériau sacrificiel (130) ;
- gravure de la portion de matériau sacrificiel (130), formant la cavité (110) dans laquelle le micro-dispositif (104) est encapsulé ;
**caractérisé en ce que** les portions de renfort mécanique (116) comprennent au moins un deuxième matériau dont le module d'Young est supérieur à celui du premier matériau, et **en ce que** chacune des portions de renfort mécanique (116) est réalisée au moins par un dépôt d'une première couche (118) du deuxième matériau et d'une deuxième couche (120) d'un troisième matériau getter métallique telles que la première couche (118) du deuxième matériau soit disposée entre la couche du premier matériau (112) et la deuxième couche (120) du troisième matériau et/ou soit recouverte par la deuxième couche (120) du troisième matériau.

13. Procédé selon l'une des revendications 11 ou 12, dans lequel le deuxième matériau est un matériau getter métallique.

14. Procédé selon l'une des revendications 11 à 13, dans lequel chacune des portions de renfort mécanique (116) est réalisée par un dépôt d'un empilement de couches (118, 120) dont au moins deux desdites couches (118, 120) forment un bilame exerçant sur le capot (106) une force dirigée vers l'extérieur de la cavité (110).

15. Procédé selon l'une des revendications 11 à 14, comportant en outre, après la solidarisation du capot (106) au substrat (102) ou la gravure de la portion de matériau sacrificiel (130), la réalisation de vias électriquement conducteurs à travers l'épaisseur du substrat (102) et/ou de la couche du premier matériau (112), à côté de la cavité (110).

16. Procédé de réalisation d'un dispositif microélectronique (1000), comportant la mise en œuvre d'un procédé d'encapsulation selon la revendication 15 formant au moins deux structures d'encapsulation (100.1, 100.2), lesdites structures d'encapsulation (100.1, 100.2) étant disposées l'une au-dessus de l'autre, au moins un via électriquement conducteur (126) d'une première (100.1) des deux structures d'encapsulation étant ensuite relié électriquement à au moins un via électriquement conducteur (126) d'une deuxième (100.2) des deux structures d'encapsulation directement ou par l'intermédiaire d'un interposeur (1010).

## Patentansprüche

1. Verkapselungsstruktur (100) für wenigstens eine Mikrovorrichtung (104), welche an und/oder in einem Substrat (102) gebildet und in wenigstens einem Hohlraum (110) angeordnet ist, welcher zwischen dem Substrat (102) und einer Haube (106) gebildet ist, welche mit dem Substrat (102) verbunden ist, wobei die Haube (106) wenigstens umfasst:
- eine Schicht (112) aus einem ersten Material, von welcher eine Fläche (114) eine innere Wand des Hohlraums (110) bildet, und
- mechanische Verstärkungsabschnitte (116), welche wenigstens mit der Fläche (114) der Schicht aus dem ersten Material (112) verbunden sind, wobei sie die Fläche (114) der Schicht aus dem ersten Material (112) teilweise bedecken und Eigenschaften eines Absorbierens und/oder Adsorbierens von Gasen aufweisen,
**dadurch gekennzeichnet, dass** die mechanischen Verstärkungsabschnitte (116) wenigstens ein zweites Material umfassen, dessen Elastizitätsmodul (116) größer ist als derjenige des ersten Materials,
und dadurch, dass jeder der mechanischen Verstärkungsabschnitte (116) wenigstens eine erste Schicht (118) aus dem zweiten Material und wenigstens eine zweite Schicht (120) aus einem dritten metallischen Gettermaterial derart umfasst, dass die erste Schicht (118) aus dem zweiten Material zwischen der Schicht aus dem ersten Material (112) und der zweiten Schicht (120) aus dem dritten Material angeordnet ist und/oder von der zweiten Schicht (120) aus dem dritten Material bedeckt ist.

2. Verkapselungsstruktur (100) nach Anspruch 1, wobei das zweite Material ein metallisches Gettermaterial ist.

3. Verkapselungsstruktur (100) nach einem der vorhergehenden Ansprüche, wobei jeder der mechanischen Verstärkungsabschnitte (116) einen Stapel von Schichten (118, 120) umfasst, von welchem wenigstens zwei der Schichten (118, 120) ein Bimetall bilden, welches auf die Haube (106) eine Kraft ausübt, welche in Richtung der Außenseite des Hohlraums (110) gerichtet ist.

4. Verkapselungsstruktur (100) nach einem der vorhergehenden Ansprüche, wobei das erste Material auf Grundlage von Si und/oder Silika und/oder Siliziumnitrid ist und das zweite Material auf Grundlage von Cr und/oder Ti und/oder Co und/oder Fe und/oder Mn und/oder Mo und/oder Ta und/oder V und/oder W und/oder Pd und/oder Rh und/oder Pt und/oder Ru und/oder Zr ist.

5. Verkapselungsstruktur (100) nach einem der Ansprüche 2 bis 4, wobei das oder die metallischen Gettermaterialien auf Grundlage von Cr und/oder Ti und/oder Co und/oder Fe und/oder Mn und/oder Mo und/oder Ta und/oder V und/oder W und/oder Pd und/oder Rh und/oder Pt und/oder Ru und/oder Zr sind.

6. Verkapselungsstruktur (100) nach einem der vorhergehenden Ansprüche, wobei jeder der mechanischen Verstärkungsabschnitte (116) von einer im Wesentlichen rechteckigen parallelepipeden Form ist, wobei die mechanischen Verstärkungsabschnitte (116) untereinander im Wesentlichen parallel sind.

7. Verkapselungsstruktur (100) nach einem der Ansprüche 1 bis 5, wobei die mechanischen Verstärkungsabschnitte (116) ein Netz an der Fläche (114) der Schicht aus dem ersten Material (112) bilden.

8. Verkapselungsstruktur (100) nach einem der vorhergehenden Ansprüche, wobei ein Verhältnis r=h/H zwischen etwa 0,6 und 0,9 beträgt und ein Verhältnis R=b/t größer oder gleich etwa 0,7 ist, mit:
h: Dicke der Schicht aus dem ersten Material (112);
H: Summe von h und der Dicke eines der mechanischen Verstärkungsabschnitte (116);
b: Breite eines der mechanischen Verstärkungsabschnitte (116);
t: Periode, mit welcher die mechanischen Verstärkungsabschnitte (116) an der Schicht aus dem ersten Material (112) angeordnet sind.

9. Verkapselungsstruktur (100) nach einem der vorhergehenden Ansprüche, ferner umfassend elektrisch leitfähige Bahnen (126), welche durch die Dicke des Substrats (102) und/oder der Schicht aus dem ersten Material (112) neben dem Hohlraum (110) gebildet sind.

10. Mikroelektronische Vorrichtung (1000), umfassend wenigstens zwei Verkapselungsstrukturen (100.1, 100.2) nach Anspruch 9, welche die eine über der anderen angeordnet sind, wobei wenigstens eine elektrisch leitfähige Bahn (126) von einer ersten (100.1) der beiden Verkapselungsstrukturen elektrisch mit wenigstens einer elektrisch leitfähigen Bahn (126) einer zweiten (100.2) der beiden Verkapselungsstrukturen direkt oder durch Vermittlung eines Zwischenelements (1010) verbunden ist.

11. Verfahren zum Verkapseln von wenigstens einer Mikrovorrichtung (104), umfassend wenigstens die Schritte:
- Bilden der Mikrovorrichtung (104) an und/oder in einem Substrat (102);
- Bilden von mechanischen Verstärkungsabschnitten (116), welche mit wenigstens einer Fläche (114) einer Schicht aus einem ersten Material (112) verbunden sind, welche wenigstens teilweise die Fläche (114) der Schicht aus dem ersten Material (112) bedecken und Eigenschaften einer Absorption und/oder einer Adsorption von Gasen aufweisen, wobei die Schicht aus dem ersten Material (112) und die mechanischen Verstärkungsabschnitte (116) eine Haube (106) bilden;
- Verbinden der Haube (106) mit dem Substrat (102) derart, dass die Mikrovorrichtung (104) in einem Hohlraum (110) verkapselt wird, welcher zwischen der Haube (106) und dem Substrat (102) gebildet ist;
**dadurch gekennzeichnet, dass** die mechanischen Verstärkungsabschnitte (116) wenigstens ein zweites Material umfassen, dessen Elastizitätsmodul größer ist als derjenige des ersten Materials, und dadurch, dass jeder der mechanischen Verstärkungsabschnitte (116) wenigstens durch Anlagern einer ersten Schicht (118) aus dem zweiten Material und wenigstens einer zweiten Schicht (120) aus einem dritten metallischen Gettermaterial derart gebildet wird, dass die erste Schicht (118) aus dem zweiten Material zwischen der Schicht aus dem ersten Material (112) und der zweiten Schicht (120) aus dem dritten Material angeordnet wird und/oder von der zweiten Schicht (120) aus dem dritten Material bedeckt wird.

12. Verfahren zum Verkapseln wenigstens einer Mikrovorrichtung (104), umfassend die Schritte:
- Bilden der Mikrovorrichtung (104) an und/oder in einem Substrat (102);
- Bilden eines Abschnitts aus einem Opfermaterial (130) wenigstens an der Mikrovorrichtung (104) und derart, dass das von dem Abschnitt aus dem Opfermaterial (130) eingenommene Volumen wenigstens einem Teil eines Volumens eines Hohlraums (110) entspricht, in welchem die Mikrovorrichtung (104) vorgesehen ist, verkapselt zu werden;
- Bilden von mechanischen Verstärkungsabschnitten (116) an und/oder in dem Abschnitt des Opfermaterials (130) und Eigenschaften einer Absorption und/oder einer Adsorption von Gasen aufweisend;
- Anlagern einer Schicht aus einem ersten Material (112), welche wenigstens die mechanischen Verstärkungsabschnitte (116) und den Abschnitt aus dem Opfermaterial (130) bedeckt;
- Ätzen des Abschnitts aus dem Opfermaterial (130), wobei der Hohlraum (110) gebildet wird, in welchem die Mikrovorrichtung (104) verkapselt wird;
**dadurch gekennzeichnet, dass** die mechanischen Verstärkungsabschnitte (116) wenigstens ein zweites Material umfassen, dessen Elastizitätsmodul (116) größer ist als derjenige des ersten Materials, und dadurch, dass jeder der mechanischen Verstärkungsabschnitte (116) wenigstens durch Anlagern einer ersten Schicht (118) aus dem zweiten Material und wenigstens einer zweiten Schicht (120) aus einem dritten metallischen Gettermaterial derart gebildet wird, dass die erste Schicht (118) aus dem zweiten Material zwischen der Schicht aus dem ersten Material (112) und der zweiten Schicht (120) aus dem dritten Material angeordnet wird und/oder von der zweiten Schicht (120) aus dem dritten Material bedeckt wird.

13. Verfahren nach einem der Ansprüche 11 oder 12, wobei das zweite Material ein metallisches Gettermaterial ist.

14. Verfahren nach einem der Ansprüche 11 bis 13, wobei jeder der mechanischen Verstärkungsabschnitte (116) durch ein Anlagern eines Stapels von Schichten (118, 120) gebildet wird, von welchen wenigstens zwei der Schichten (118, 120) ein Bimetall bilden, welches auf die Haube (106) eine Kraft ausübt, welche in Richtung der Außenseite des Hohlraums (110) gerichtet ist.

15. Verfahren nach einem der Ansprüche 11 bis 14, ferner umfassend nach dem Verbinden der Haube (106) mit dem Substrat (102) und dem Ätzen des Abschnitts aus dem Opfermaterial (130) das Bilden von elektrisch leitfähigen Bahnen durch die Dicke des Substrats (102) und/oder der Schicht aus dem ersten Material (112) neben dem Hohlraum (110).

16. Verfahren zum Herstellen einer mikroelektronischen Vorrichtung (1000), umfassend das Durchführen eines Verkapselungsverfahrens nach Anspruch 15, wobei wenigstens zwei Verkapselungsstrukturen (100.1, 100.2) gebildet werden, wobei die Verkapselungsstrukturen (100.1, 100.2) eine über der anderen angeordnet werden, wobei wenigstens eine elektrisch leitfähige Bahn (126) einer ersten (100.1) der beiden Verkapselungsstrukturen danach elektrisch mit wenigstens einer elektrisch leitfähigen Bahn (126) einer zweiten (100.2) der beiden Verkapselungsstrukturen direkt oder durch Vermittlung eines Zwischenelements (1010) verbunden wird.

## Claims

1. Encapsulation structure (100) of at least one microdevice (104) made on and/or in a substrate (102) and arranged in at least one cavity (110) formed between the substrate (102) and a cap (106) rigidly attached to the substrate (102), in which the cap (106) includes at least:
- one layer (112) of a first material, one face of which (114) forms an inner wall of the cavity (110), and
- mechanical reinforcement portions (116) rigidly connected to at least said face (114) of the layer of the first material (112), partly covering said face (114) of the layer of the first material (112), and having gas absorption and/or adsorption properties,
**characterized in that** these mechanical reinforcement portions (116) include at least one second material, the Young's modulus of which is higher than that of the first material,
and **in that** each of the mechanical reinforcement portions (116) includes at least one first layer (118) of the second material, and at least one second layer (120) of a third metallic getter material such that the first layer (118) of the second material is arranged between the layer of the first material (112) and the second layer (120) of the third material and/or is covered by the second layer (120) of the third material.

2. Encapsulation structure (100) according to claim 1, in which the second material is a metallic getter material.

3. Encapsulation structure (100) according to one of previous claims, in which each of the mechanical reinforcement portions (116) includes a stack of layers (118, 120) of which at least two of said layers (118, 120) form a bimetallic strip exerting on the cap (106) a force directed outside of the cavity (110).

4. Encapsulation structure (100) according to one of previous claims, in which the first material is based on Si and/or silica and/or silicon nitride, and the second material is based on Cr and/or Ti and/or Co and/or Fe and/or Mn and/or Mo and/or Ta and/or V and/or W and/or Pd and/or Rh and/or Pt and/or Ru and/or Zr.

5. Encapsulation structure (100) according to one of claims 2 to 4, in which the metallic getter material(s) comprise Cr and/or Ti and/or Co and/or Fe and/or Mn and/or Mo and/or Ta and/or V and/or W and/or Pd and/or Rh and/or Pt and/or Ru and/or Zr.

6. Encapsulation structure (100) according to one of previous claims, in which each of the mechanical reinforcement portions (116) is of roughly rectangular parallelepipedic shape, and where the mechanical reinforcement portions (116) are arranged roughly parallel to one another.

7. Encapsulation structure (100) according to one of claims 1 to 5, in which the mechanical reinforcement portions (116) form a mesh on said face (114) of the layer of the first material (112).

8. Encapsulation structure (100) according to one of previous claims, in which a ratio r = h/H is between about 0.6 and 0.9, and a ratio R = b/t is greater than or equal to about 0.7, where:
h: thickness of the layer of the first material (112);
H: sum of h and of the thickness of one of the mechanical reinforcement portions (116);
b: width of one of the mechanical reinforcement portions (116);
t: period with which the mechanical reinforcement portions (116) are arranged on the layer of the first material (112).

9. Encapsulation structure (100) according to one of previous claims, also including electrically conductive vias (126) made all the way through the substrate (102) and/or the layer of the first material (112), next to the cavity (110).

10. Microelectronic device (1000) including at least two encapsulation structures (100.1, 100.2) according to claim 9, arranged one above the other, in which at least one electrically conductive via (126) of a first (100.1) of the two encapsulation structures is electrically connected to at least one electrically conductive via (126) of a second (100.2) of the two encapsulation structures, directly or through an interposer (1010).

11. Method of encapsulation of at least one microdevice (104), including at least the following steps:
- production of the microdevice (104) on and/or in a substrate (102);
- production of mechanical reinforcement portions (116) rigidly attached to at least one face (114) of a layer of a first material (112), partly covering said face (114) of the layer of the first material (112), and having gas absorption and/or adsorption properties, where the layer of the first material (112) and the mechanical reinforcement portions (116) form a cap (106);
- rigid attachment of the cap (106) to the substrate (102) such that the microdevice (104) is encapsulated in a cavity (110) formed between the cap (106) and the substrate (102);
**characterized in that** the mechanical reinforcement portions (116) include at least one second material, the Young's modulus of which is higher than that of the first material, and **in that** each of the mechanical reinforcement portions (116) is produced at least by a deposition of a first layer (118) of the second material, and of a second layer (120) of a third metallic getter material such that the first layer (118) of the second material is arranged between the layer of the first material (112) and the second layer (120) of the third material and/or is covered by the second layer (120) of the third material.

12. Method of encapsulation of at least one microdevice (104), including at least the following steps:
- production of the microdevice (104) on and/or in a substrate (102);
- production of a portion of sacrificial material (130) at least on the microdevice (104) and such that the volume occupied by the portion of sacrificial material (130) corresponds to at least one part of a volume of a cavity (110) in which the microdevice (104) is intended to be encapsulated;
- production of mechanical reinforcement portions (116) on and/or in the portion of sacrificial material (130) and having gas absorption and/or adsorption properties;
- deposition of a layer of a first material (112) covering at least the mechanical reinforcement portions (116) and the portion of sacrificial material (130);
- etching of the portion of sacrificial material (130), forming the cavity (110) in which the microdevice (104) is encapsulated;
**characterized in that** the mechanical reinforcement portions (116) include at least one second material, the Young's modulus of which is higher than that of the first material, and **in that** each of the mechanical reinforcement portions (116) is produced at least by a deposition of a first layer (118) of the second material, and of a second layer (120) of a third metallic getter material such that the first layer (118) of the second material is arranged between the layer of the first material (112) and the second layer (120) of the third material and/or is covered by the second layer (120) of the third material.

13. Method according to one of claims 11 or 12, in which the second material is a metallic getter material.

14. Method according to one of claims 11 to 13, in which each of the mechanical reinforcement portions (116) is produced by deposition of a stack of layers (118, 120) of which at least two of said layers (118, 120) form a bimetallic strip exerting on the cap (106) a force directed outside of the cavity (110).

15. Method according to one of claims 11 to 14, also including, after rigid attachment of the cap (106) to the substrate (102), or etching of the portion of sacrificial material (130), production of electrically conductive vias all the way through the substrate (102) and/or the layer of the first material (112), next to the cavity (110).

16. Method for production of a microelectronic device (1000), including implementation of a method of encapsulation according to claim 15 forming at least two encapsulation structures (100.1, 100.2), where said encapsulation structures (100.1, 100.2) are arranged one above the other, and where at least one electrically conductive via (126) of a first (100.1) of the two encapsulation structures is then electrically connected to at least one electrically conductive via (126) of a second (100.2) of the two encapsulation structures directly or through an interposer (1010).
